(19) Europäisches Patentamt
European Patent Office
Office européen des brevets

(11) **EP 1 574 862 B1**

(12) **EUROPEAN PATENT SPECIFICATION**

(45) Date of publication and mention
of the grant of the patent:
**14.11.2012 Bulletin 2012/46**

(51) Int Cl.:
*G01P 15/09* (2006.01)    *H03F 3/08* (2006.01)
*H03F 3/45* (2006.01)    *H03F 3/70* (2006.01)

(21) Application number: **04380054.9**

(22) Date of filing: **09.03.2004**

(54) **Charge-type and current-type sensors amplifying circuit**

Verstärkerschaltung für einen Ladungssensor oder einen Stromsensor

Circuit amplificateur pour un capteur de type à charge ou à courant

(84) Designated Contracting States:
**AT BE BG CH CY CZ DE DK EE ES FI FR GB GR HU IE IT LI LU MC NL PL PT RO SE SI SK TR**

(43) Date of publication of application:
**14.09.2005 Bulletin 2005/37**

(73) Proprietor: **Azkoyen, S.A.**
**31350 Peralta Navarra (ES)**

(72) Inventors:
• **Carlosena Garcia, Alfonso**
**31192 Multiva Alta (Navarra) (ES)**
• **Baztàn Oiza, Jesùs**
**31007 Pamplona (Navarra) (ES)**
• **Fernandez de Muniain Comajuncosa, Javier**
**31012 Pamplona (Navarra) (ES)**
• **Pina Insausti, Jose Luis**
**31008 Pamplona (Navarra) (ES)**

(74) Representative: **Davila Baz, Angel et al**
C/o Clarke, Modet & Co.
**Goya, 11**
**28001 Madrid (ES)**

(56) References cited:
EP-A- 0 315 259    US-A- 5 670 775
US-A1- 2003 218 508    US-B1- 6 323 734

• GANDELLI A ET AL: "Charge amplifiers for piezoelectric sensors", PROCEEDINGS OF THE INSTRUMENTATION AND MEASUREMENT TECHNOLOGY CONFERENCE. ORVINE, CA., MAY 18 - 20, 1993; [PROCEEDINGS OF THE INSTRUMENTATION AND MEASUREMENT TECHNOLOGY CONFERENCE], NEW YORK, IEEE, US, vol. -, 18 May 1993 (1993-05-18), pages 465-468, XP010131439, DOI: 10.1109/IMTC. 1993.382598 ISBN: 978-0-7803-1229-6

## Description

Field of the invention

The present invention relates to amplifying differential input circuits for charge-type or current-type sensors, for amplifying, conditioning and outputting the output from charge-type or current-type sensors such as acceleration and light-detecting (photodiode) sensors, respectively.

Description of the related art

Hitherto, piezoelectric-type acceleration sensing devices, pyroelectric-type infrared sensing devices and the like have been known as sensing devices that produce a signal, which directly depends on the physical variable to be measured, in the form of electrical charges. Since the amount of charge produced is very small, typically in the range of Pico Coulombs, an amplifying circuit is needed to produce a measurable voltage in the range of some hundreds of mili-volts. These kinds of devices are known as charge-amplifiers, and can be considered as a subclass of the so called transimpedance amplifiers or transimpedance converters.

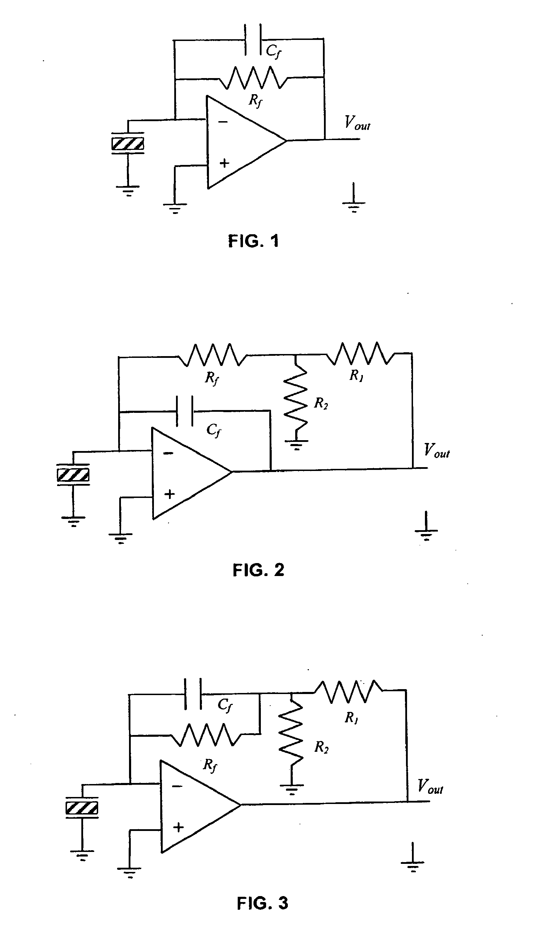

Charge amplifiers must have additional properties such as low input and output impedances, in such a way that the output signal is almost independent of the parasitic impedances of the sensor and of the subsequent electronics. A well-known and simple topology which fulfils the requirements is shown in Figure 1, and is originally credited to W. Kistler. A capacitor $C_f$ is connected between the inverting input of the high gain voltage differential amplifier and its output. The non-inverting input of the amplifier is connected to the reference voltage. An operational amplifier (op amp) usually implements the high gain differential amplifier, though a simple FET transistor can be used instead. The voltage at the output, when the charge generated by the sensor is Q, can be calculated as:

$$V_o = Q/C_f$$

Thus, sensitivity of the amplifier is

$$1/C_f$$

Usually, a resistor $R_f$ is connected in parallel with $C_f$ in order to allow a proper biasing for the op amp and a DC path to guarantee stability. However $R_f$ also introduces a lower cut-off frequency. The dynamic response of the amplifier becomes then:

$$V_o = -\frac{Q}{C_f\left(1+\dfrac{1}{sR_fC_f}\right)}$$

Where from the cut-off frequency can be calculated as:

$$\omega = \frac{1}{R_fC_f}$$

This means that the amplifier has a minimum usable frequency, which can be reduced as much as possible by increasing $R_f$, while keeping a constant $C_f$ value in order to preserve the sensitivity of the amplifier in the flat region of the frequency response.

A number of modifications for this basic scheme, with the aim to improve a given feature of the amplifier or to overcome a limitation, has been disclosed. For instance a resistive "T" as shown in Figure 2 can replace resistor $R_f$. The equivalent resistance seen now by the charge is:

$$R_f(1+R_1/R_2+R_1/R_f)$$

In this way, large resistance values can be achieved by properly choosing the ratio $R_1/R_2$, without resorting to large-valued resistors. The basic idea of boosting a resistance value is well known, as shown in many basic textbooks, and is applied to the charge-type amplifier in the issued patent US-6,104,120. The sensitivity of the charge amplifier in the flat region of the frequency response does not change, remaining equal to $1/C_f$.

A limitation of the schemes of both figures 1 and 2 is the lack of an independent control for the sensitivity of the amplifier, which can only be modified by varying $C_f$, but changing in the same proportion the cut-off frequency. To overcome such limitation, a modification has been disclosed by Murata and shown in figure 3. Capacitor $C_f$ and resistor $R_f$ are connected in parallel, being one of the common terminals connected to the amplifier inverting input. A resistive divider formed by $R_2$ and $R_1$ is connected between the amplifier output and the reference, being the voltage dividing point of the divider connected to the other common terminal of $R_f$ and $C_f$. The sensitivity of this new circuit becomes.

$$(1/C_f).(1+R_1/R_2)$$

And the cut-off frequency remains unchanged. Actually, the feedback configuration of the charge amplifier can be seen as a T network whose aim is to boost sensitivity by increasing the effective impedance of the capacitor.

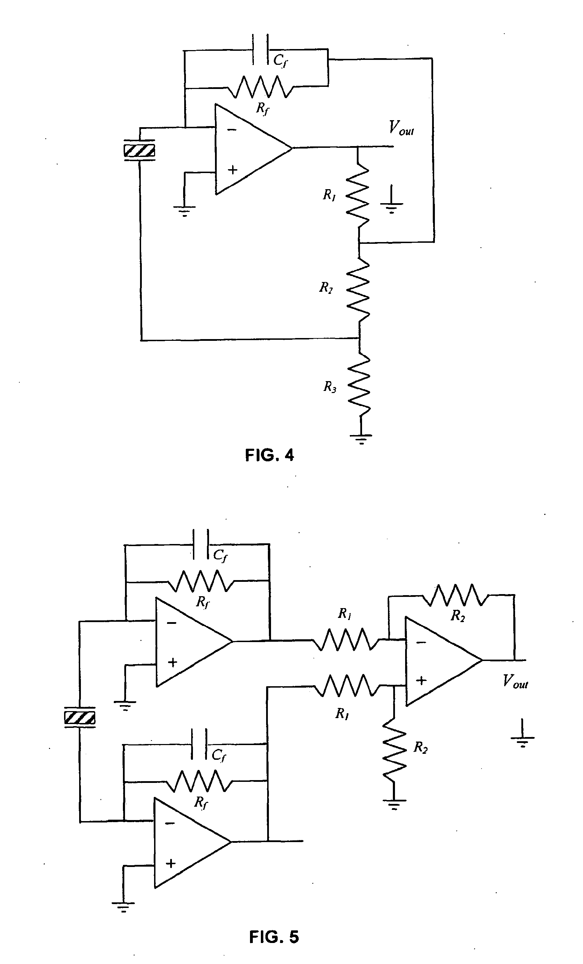

A closely related topology, from which the embodiment of figure 3 is a particular case, is disclosed in EP-1150125, and shown in figure 4. Here, a voltage divider including three resistors $R_1$, $R_2$, and $R_3$ is used. The voltage dividing points are connected to one sensor terminal and to the common connecting terminal of $C_f$ and $R_f$, respectively. Such scheme can provide simultaneously sensitivity control, through $R_1$, and temperature compensation, through $R_2$ and $R_3$. A limitation of this scheme is that no virtual short is induced between the two terminals of the sensors, and thus some dependence on its parasitic impedance should be expected.

A common limitation to all of the above mentioned schemes (figures 1 to 4), is that they are very sensitive to common mode noise and interference, such as that produced by electrostatic coupling. Such common mode signals, in the form of currents are simultaneously injected on both sensor terminals with likely the same intensity. Since one of the terminals is connected to the voltage reference, no cancellation or compensation is possible.

Several schemes have been proposed to cope with the mentioned limitation, and most of them make use either fully differential or balanced configurations. Examples of balanced configurations are for instance disclosed in patents US-5,339,285, US-5,982,232, and are also proposed in "Transimpedance amplifier with differential photodiode current sensing", by Bahram Zand, Khoman Phang, and David A. Johns, IEEE International Symposium on Circuits and Systems, ISCAS 99. They require the use of a high-gain balanced amplifier, which is not easily built with operational amplifiers. Regarding fully differential configurations, they are well known and have been described for photodiode sensors. (B.C. Baker, "Comparison of noise performance between a FET transimpedance amplifier and a switched integrator", Application Bulletin AB-075A, 1993 Burr-Brown Corporation, USA) and also for charge amplifiers ("Charge amplifiers for piezoelectric sensors", A. Gandelli, R. Ottoboni, IEEE International Measurement and Technology Conference, IMTC 1993). Practical embodiments using operational amplifiers for piezoelectric sensors, such as the one shown in figure 5, are disclosed in patents US-4,689,578 and US-5,388,458.

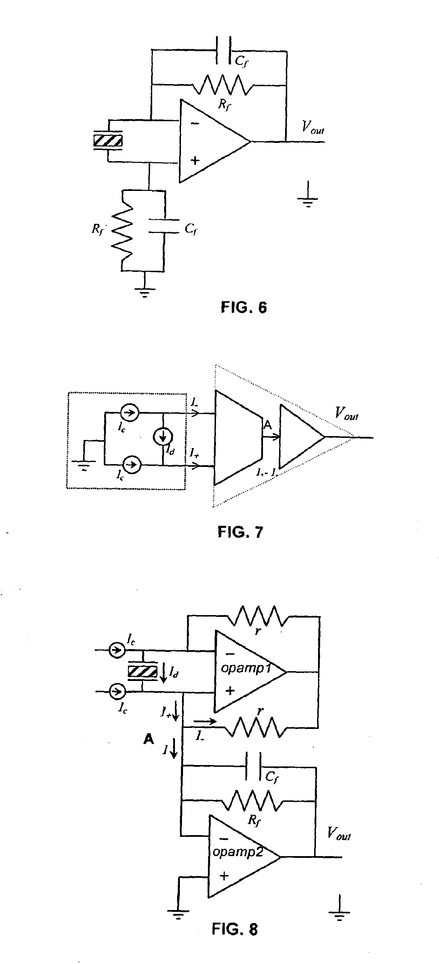

All of the schemes mentioned, which cancel out the common mode interference or noise, require the use of at least three operational amplifiers, and a number of resistors, making the solution expensive with respect to the basic current amplifier with a single op amp. Moreover, common mode cancellation is not independent of the transimpedance of the circuit and thus gain and compensation cannot be adjusted fully independently. An alternative, shown in figure 6, has been recently disclosed in US-2002/0125943 for charge generating sensors, which was also previously known and described for current generating sensors (G. Graeme, "Photodiode monitoring with opamps" Application Bulletin AB-075, January 1995, Burr-Brown Corporation, USA), making use of only a single operational amplifier. However, and differently from the schemes described so far, it produces signal variations at the operational input, which no longer remain at a voltage close to the reference voltage. Moreover, to achieve effective noise cancellation, it requires a perfect matching between the passive components, which is practically difficult particularly for capacitors. Another drawback is that compensation is also dependent on voltage offsets of the operational amplifier. To cope with these limitations, a novel topology and several embodiments are proposed.

### Summary of the invention

The present invention relates to amplifying differential input circuits for charge-type and current-type sensors according to claims 1, 2, and 3.

Accordingly, it is an object of the present invention to provide an amplifying and conditioning circuit for electric charge- and current-type sensors in which the common mode noise and interference is cancelled. The circuit of the invention provides a voltage at the output $V_{out}$ in response to the sensor excitation, which is in the form of current or charge. The idea is to produce a cancellation of common mode charge (or current), and simultaneously sum up differential currents (or charge) from the very beginning, and as close to the sensor as possible. The resulting signal is then amplified and converted to voltage by a transimpedance amplifier or converter to give a voltage at the output $V_{out}$ which is proportional to the current or charge provided by the sensor, as the case may be.

Thus, the invention refers to an amplifying and conditioning circuit for a charge- or current- generating sensor, whose output voltage $V_{out}$ is proportionable to the charge or current provided by the sensor, respectively, the circuit including a reference voltage. The circuit includes a node A, the current $I$ provided at said node A of the circuit cancels out the common-mode current noise $I_c$ from said sensor and adds up the differential currents $I_d$ given by the sensor, and

the circuit comprises means for converting said current I to voltage.

That is, at node A common-mode signals are cancelled out while differential signals are added. Then, current I is converted to voltage by, for example, a suitable transimpedance.

According to the invention, the input of the circuit is floating, meaning that none of the sensor terminals is connected to a reference voltage, also forcing a virtual short (low impedance) between the sensor terminals.

Some advantages of the present invention are:

- Given that current and charge are related by a differentiation operation, the cancellation circuit is valid for charge-type and current-type sensors, and thus can be used as a preliminary stage for both charge and current amplifiers.
- Any known single ended transimpedance amplifier, uncompensated or not, can be used, summing the advantages of the cancellation circuit to that of the amplifier, in terms of frequency response, sensitivity, etc.
- Sensitivity adjustments, by the current or charge amplifier, are independent on the common mode cancellation adjustment.

The circuit of the invention can be implemented in several ways, by using operational amplifiers, giving several possible embodiments of the invention.

The circuit comprises at least: first and second operational amplifiers, two resistors of equal value r, a resistor $R_f$ and a capacitor $C_f$ and said node A.

According to one preferred embodiment of the circuit:

- said charge or current generating sensor is connectable between the two input terminals of said first operational amplifier,
- said first resistor r is connected between the inverting terminal of said first operational amplifier and its output,
- said second resistor r is connected between the non-inverting terminal of said first operational amplifier and its output,
- non-inverting terminal of said first operational amplifier is connected to the inverting terminal of said second operational amplifier,
- non-inverting terminal of said second operational amplifier is connected to the reference voltage, and
- a parallel connection of said capacitor $C_f$ and said resistor $R_f$ is connected between inverting input of said second operational amplifier and its output, which is also the output of the circuit,
- said node A being determined by the common connections of the second resistor r, the non-inverting terminal of said first operational amplifier, the inverting terminal of said second operational amplifier, the capacitor $C_f$ and the third resistor $R_f$.

Some additional advantages of this first preferred embodiment are:

- It only uses two operational amplifiers, in comparison with the three op amps used by most balanced or fully differential charge amplifiers.
- Global sensitivity is increased by a factor of two, with respect to sensitivity attained by the single op amp amplifier.
- It is inherently compensated with respect to operational voltage offsets.

- If compared with circuit in figure 6 (prior art) or other balanced configurations, it does not require capacitor matching, and also voltages at op amp inputs are always tied to the reference voltage, making it possible the use of op amps with limited rail-to-rail swing.

According to another preferred embodiment of the circuit:

- said charge or current generating sensor is connectable between inverting terminal of said first operational amplifier and inverting terminal of said second operational amplifier,
- said first resistor r is connected between the inverting terminal of said first operational amplifier and its output,
- said second resistor r is connected between the inverting terminal of said second operational amplifier and the output of said first operational amplifier,
- the non-inverting terminals of said first and second operational amplifiers are connected to the reference voltage,
- a parallel connection of said capacitor $C_f$ and said resistor $R_f$ is connected between inverting terminal of said second operational amplifier and its output, which is also the output of the circuit,
- said node A being determined by the common connections of the second resistor r, the inverting terminal of the second operational amplifier, the capacitor $C_f$ and the third resistor $R_f$.

In another third preferred embodiment of the circuit:

- said charge or current generating sensor is connectable between inverting terminal of said first operational amplifier and inverting terminal of said second operational amplifier,
- said first resistor r is connected between the inverting terminal of said first operational amplifier and its output,
- said second resistor r is connected between the inverting terminal of said second operational amplifier and the output of said first operational amplifier,
- the non-inverting terminals of said first and second operational amplifiers are connected to the reference voltage,
- a parallel connection of said capacitor $C_f$ and said resistor $R_f$ is connected between inverting terminal of said first operational amplifier and the output of said second operational amplifier, which is also the output of the circuit,
- said node A being determined by the common connections of the first resistor r, the inverting terminal of said first operational amplifier, the capacitor $C_f$ and the third resistor $R_f$.

As it has been indicated herein before, said sensor can be a charge generating sensor, such as a piezoelectric sensor or a pyroelectric sensor; or said sensor may be a current generating sensor, such as a photodiode.

All of the preferred embodiments described here can be used either as charge amplifiers, for any kind of charge generating sensors, or as transimpedance amplifiers for current generating sensors. The main difference between these two cases is that in the former, capacitor $C_f$ is chosen to provide the proper gain, and $R_f$ is tuned to achieve the desired low cut-off frequency, whereas in the latter $R_f$ is chosen to fix the desired transimpedance, and $C_f$ is adjusted to limit noise bandwidth.

Brief description of the drawings

Figure 1 shows a typical scheme of charge amplifier with a single op amp, as it is used, for instance, for piezoelectric sensors (prior art).

Figure 2 shows a well known modification of the scheme shown in figure 1 which reduces the low cut-off frequency, while preserving sensitivity (prior art)

Figure 3 shows another modification of the basic circuit in figure 1, in order to provide sensitivity control. (prior art).

Figure 4 shows a more general modification that allows sensitivity control and temperature compensation with respect to the parasitic capacitances of the sensor. (prior art).

Figure 5 shows a typical fully differential charge amplifiers making use of three operational amplifiers (prior art).

Figure 6 shows a single op amp, charge amplifier which compensates for the common mode noise (prior art).

Figure 7 shows a general scheme.

Fig. 8 shows a preferred embodiment of the invention, using two op amps.

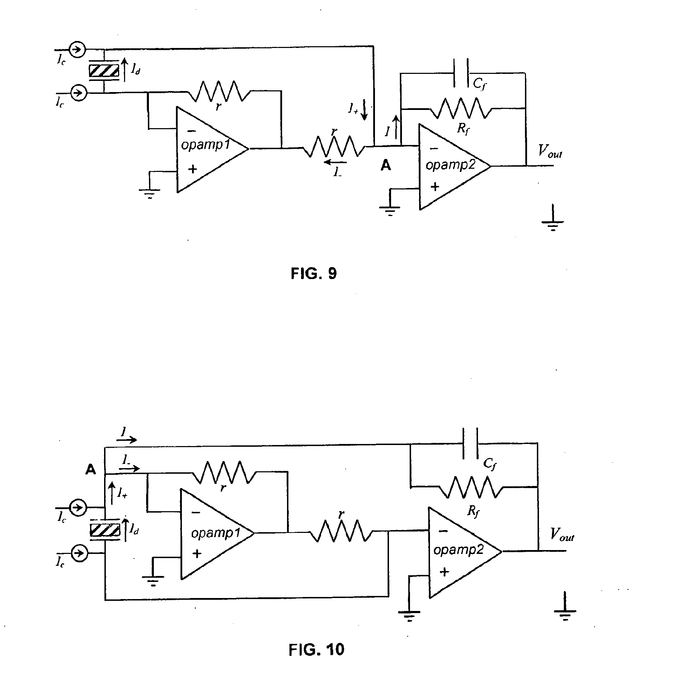

Fig. 9 shows another embodiment of the invention, using two op amps.

Fig. 10 shows an alternative circuit, with the same operation of circuits in figure 8 and 9.

As it has been indicated above, the schemes shown in figures 1 to 7 are examples of the prior art.

Figure 7 shows a general scheme, which is composed of two subcircuits with a common node A where common-mode current cancellation occurs, being subsequently converted to voltage by a suitable transimpedance.

As shown in figure 7, the input of the circuit is floating, that is, none of the sensor terminals is connected to the reference voltage, thereby forcing a virtual short (low impedance) between the sensor terminals. The currents generated at the sensor terminals are subtracted at common node A, giving a current:

$$I = I_+ - I_-$$

Since

$$I_+ = I_d + I_c$$

wherein $I_d$ represents the desired differential current generated by the sensor, and $I_c$ the common mode induced noise or interference; and also:

$$I_- = I_c - I_d$$

Then:

$$I = 2I_d$$

which implies that common mode signals are cancelled out while differential signals are added. Then, current $I$ is afterwards converted to voltage by a suitable transimpedance.

Description of the preferred embodiments

Circuit in figure 8 shows a first preferred embodiment of the invention. Charge (or current) generating sensor is connectable to the two inputs of operational amplifier *opamp1*. A resistor r is connected between the inverting terminal of operational amplifier *opamp1* and its output, and another resistor of equal value is connected between the non-inverting terminal and the output of *opamp1*. Non-inverting terminal of *opamp1* is connected to the inverting terminal of *opamp2,* while non-inverting terminal of *opamp2* is connected to the reference voltage. A parallel connection of a capacitor $C_f$ and a resistor $R_f$, is connected between inverting terminal of *opamp2* and its output, which is also the output of the circuit.

The current at node A entering impedances $R_f$ and $C_f$, which are connected to the non-inverting terminal of *opamp1* can be calculated as:

$$I = I_+ - I_-$$

It is obvious that

$$I_+ = I_d + I_c$$

Where $I_d$ represents the differential current generated by the sensor, and $I_c$ the common mode induced noise or interference. A circuit analysis shows that

$$I = I_c - I_d$$

And thus the result

$$I = 2I_d$$

Finally, the voltage at the output is

$$V_{out} = -\frac{2I_d}{C_f s\left(1 + \frac{1}{s R_f C_f}\right)}$$

There are some other possible embodiments with exactly the same passive and active elements which are equivalent, in terms of performance, to the one shown in figure 8. They are shown in figures 9 and 10. While the circuit in figure 9 complies with the general scheme shown in figure 7, the circuit in figure 10 is a circuital modification, based on the so called op amp relocation transformation, which, being equivalent, does not follow the same general scheme.

Another preferred embodiment of the basic scheme in figure 7 is circuit in figure 9. This circuit also comprises two operational amplifiers *opamp1, opamp2,* two resistors of equal value r and a resistor $R_f$ and capacitor $C_f$ Charge (or current) generating sensor is connectable between the inverting input of *opamp1* and inverting input of *opamp2.* A resistor r is connected between the inverting terminal of *opamp1* and its output, and another resistor r of identical value is connected between the inverting terminal of *opamp2* and the output of *opamp1.* Non-inverting terminals of *opamp1* and *opamp2* are connected to the reference voltage. A parallel connection of a capacitor $C_f$ and a resistor $R_f$ is connected between inverting input of *opamp2* and its output, forming a basic charge amplifier that is the output stage of the circuit. The response of this circuit, assuming ideal operational amplifiers, is identical to that of circuit in figure 8.

Another preferred embodiment can be obtained by applying a so called "op amp relocation transformation", to the circuit in figure 9, and is shown in figure 10. This circuit comprises two operational amplifiers, *opamp1, opamp2,* two resistors of equal value r and a resistor $R_f$ and a capacitor $C_f$. Charge (or current) generating sensor is connectable between the inverting input of *opamp1* and inverting input of *opamp2.* One resistor r is connected between the inverting terminal of *opamp1* and its output, and the resistor r of identical value is connected between the inverting terminal of *opamp2* and the output of *opamp1.* Non-inverting terminals of *opamp1* and *opamp2* are connected to the reference voltage. A parallel connection of a capacitor $C_f$ and a resistor $R_f$ is connected between inverting terminal of *opamp1* and the output of *opamp2,* which is also the circuit output.

## Claims

1. Amplifying and conditioning differential input circuit for a charge- or current-generating sensor having sensor terminals suitable for generating a common mode noise current ($I_c$) and differential currents ($I_d$), the output voltage $V_{out}$ of the differential input circuit being proportionable to the charge or current provided by the sensor, respectively, the differential input circuit including a reference voltage, and comprising:

   a first and a second resistor (*r*) of equal value, a first and a second operational amplifier (*opamp1, opamp2*), a parallel connection of a capacitor ($C_f$) and a third resistor ($R_f$);
   a node (A), the differential input circuit being configured to provide a current (*I*) at said node (A) for cancelling out the common mode noise current ($I_c$) and for adding up the differential currents ($I_d$), and
   means for converting said current (*I*) to voltage;

   wherein:

   - the two input terminals of the first operational amplifier (opamp1) are arranged to be respectively connectable with the sensor terminals,
   - the first resistor (*r*) is connected between the inverting terminal of said first operational amplifier (opamp1) and its output,
   - the second resistor of equal value (*r*) is connected between the non-inverting terminal of said first operational amplifier (opamp1) and its output,
   - non-inverting terminal of said first operational amplifier (opamp1) is connected to the inverting terminal of the second operational amplifier (opamp2),
   - non-inverting terminal of said second operational amplifier (opamp2) is connected to the reference voltage, and
   - the parallel connection of the capacitor ($C_f$) and the third resistor ($R_f$) is connected between the inverting terminal of said second operational amplifier (opamp2) and its output, which is also the output of the circuit said node (A) being determined by the common connections of the second vesistor, the non-inventing terminal of said first operational amplifier (opamp1), the inventing terminal 1/3 of said second operational amplifier (opamp2), the capacitor($C_f$) and the thirch resistor ($R_f$), resistor ($R_f$).

2. Amplifying and conditioning differential input circuit for a charge- or current-generating sensor having sensor terminals suitably for generating a common mode noise current ($I_c$) and differential currents ($I_d$), the output voltage $V_{out}$ of the differential input circuit being proportionable to the charge or current provided by the sensor, respectively, the differential input circuit including a reference voltage 35 , and comprising

a first and a second resistor ($r$) of equal value, a first and a second operational amplifier (*opamp1, opamp2*), a parallel connection of a capacitor ($C_f$) and a third resistor ($R_f$);
a node (A), the differential input circuit being configured to provide a current (*I*) at said node (A) for cancelling out the common mode noise current ($I_c$) and for adding up the differential currents ($I_d$), and
means for converting said current (*I*) to voltage;
wherein:

- the inverting terminal of the first operational amplifier (opamp1) and the inverting terminal of the second operational amplifier (opamp2) are arranged to be respectively connectable with the sensor terminals,
- the first resistor ($r$) is connected between the inverting terminal of said first operational amplifier (opamp1) and its output,
- the second resistor of equal value ($r$) is connected between the inverting terminal of said second operational amplifier (opamp2) and the output of said first operational amplifier (opamp1),
- the non-inverting terminals of said first and second operational amplifiers (opamp1, opamp2) are connected to the reference voltage,
- the parallel connection of the capacitor ($C_f$) and the third resistor ($R_f$) is connected between the inverting terminal of said second operational amplifier (opamp2) and its output, which is also the output of the circuit said node (A) bieng determined by the common connections of the second resistor (r), the inverting terminal of the second operational amplifier (opamp2), the capacitor ($C_f$) and the third resistor ($R_f$).

3. Amplifying and conditioning differential input circuit for a charge- or current-generating sensor having sensor terminals, suitable for generating a common mode noise current ($I_c$) and 25 differential currents ($I_d$), the output voltage $V_{out}$ of the differential input circuit being proportionable to the charge or current provided by the sensor, respectively, the differential input circuit including a reference voltage, and comprising:

a first and a second resistor ($r$) of equal value, a first and a second operational amplifier (*opamp1, opamp2*), a parallel connection of a capacitor ($C_f$) and a third resistor ($R_f$);
a node (A), the differential input circuit being configured to provide a current (*I*) at said node (A) for cancelling out the common mode noise current ($I_c$) and for adding up the differential currents ($I_d$), and
means for converting said current (I) to voltage;

wherein:

- the inverting terminal of the first operational amplifier (opamp1) and the inverting terminal of the second operational amplifier (opamp2) are arranged to be respectively connectable with the sensor terminals,
- the first resistor ($r$) is connected between the inverting terminal of said first operational amplifier (opamp1) and its output,
- the second resistor of equal value ($r$) is connected between the inverting terminal of said second operational amplifier (opamp2) and the output of said first operational amplifier (opamp1),
- the non-inverting terminals of said first and second operational amplifiers (opamp1, opamp2) are connected to the reference voltage,
- the parallel connection of the capacitor ($C_f$) and the third resistor ($R_f$) is connected between the inverting terminal of said first operational amplifier (opamp1) and the output of said second operational amplifier (opamp2), which is also the output of the circuit, said node (A) being determined by the common connections of the first resistor (r), the inventing terminal of said first operational amplifier (opamp1), the capacitor ($C_f$) and the third resistor ($R_f$).

**Patentansprüche**

1. Verstärker- und Aufbereitungsdifferenzeingangskreis für einen eine Ladung oder Strom erzeugenden Sensor, welcher Sensoranschlüsse aufweist, geeignet für die Erzeugung von einem Gleichtaktrauschstrom ($I_d$) und Differenzströmen ($I_d$), wobei die Ausgangsspannung $V_{out}$ des Differenzeingangskreises jeweils im richtigen Verhältnis in Bezug auf die von dem Sensor bereitgestellte Ladung oder den bereitgestellten Strom steht, wobei der Differenzeingangskreis eine Referenzspannung enthält, und umfassend:

einen ersten und einen zweiten Widerstand (r) mit demselben Wert, einen ersten und einen zweiten Operationsverstärker (opamp1, opamp2), eine Parallelschaltung eines Kondensators ($C_f$) und einen dritten Widerstand ($R_f$);

einen Knoten (A), wobei der Differenzeingangskreis für die Bereitstellung eines Stroms (I) an dem genannten Knoten (A) für die Aufhebung des Gleichtaktrauschstroms ($I_c$) und für die Summierung der Differenzströmen ($I_d$) ausgebildet ist, und
Mittel für die Umwandlung des genannten Stroms (I) in Spannung;
in welchem:

- beide Eingangsanschlüsse des ersten Operationsverstärkers (opamp1) so angeordnet sind, dass sie jeweils mit den Sensoranschlüssen angeschlossen werden können,
- der erste Widerstand (r), zwischen dem invertierenden Anschluss des genannten ersten Operationsverstärkers (opamp1) und seinem Ausgang angeschlossen ist,
- der zweite Widerstand mit demselben Wert (r) zwischen dem nicht invertierenden Anschluss des genannten ersten Operationsverstärkers (opamp1) und seinem Ausgang angeschlossen ist,
- der nicht invertierende Anschluss des genannten ersten Operationsverstärkers (opamp1) mit dem invertierenden Anschluss des zweiten Operationsverstärkers (opamp2) angeschlossen ist,
- der nicht invertierende Anschluss des genannten zweiten Operationsverstärkers (opamp2) mit der Referenzspannung angeschlossen ist, und
- die Parallelschaltung des Kondensators ($C_f$) und der dritte Widerstand ($R_f$) zwischen dem invertierenden Anschluss des genannten zweiten Operationsverstärkers (opamp2) und seinem Ausgang angeschlossen ist, wobei dieser ebenso der Ausgang des Kreises ist,
- wobei der genannte Knoten (A) durch die gemeinsame Schaltungen des zweiten Widerstands, des nicht invertierenden Anschlusses des genannten ersten Operationsverstärkers (opamp1), des invertierenden Anschlusses des genannten zweiten. Operationsverstärkers (opamp2), des Kondensators ($C_f$) und des dritten Widerstands ($R_f$) bestimmt wird.

2. Verstärker- und Aufbereitungsdifferenzeingangskreis für einen eine Ladung oder Strom erzeugenden Sensor, welcher Sensoranschlüsse aufweist, geeignet für die Erzeugung von einem Gleichtaktrauschstrom ($I_c$) und Differenzströmen ($I_d$), wobei die Ausgangsspannung $V_{out}$ des Differenzeingangskreises jeweils im richtigen Verhältnis in Bezug auf die von dem Sensor bereitgestellte Ladung oder den bereitgestellten Strom steht, wobei der Differenzeingangskreis eine Referenzspannung enthält, und umfassend:

einen ersten und einen zweiten Widerstand (r) mit demselben Wert, einen ersten und einen zweiten Operationsverstärker (opamp1, opamp2), eine Parallelschaltung eines Kondensators ($C_f$) und einen dritten Widerstand ($R_f$);
einen Knoten (A), wobei der Differenzeingangskreis für die Bereitstellung eines Stroms (I) an dem genannten Knoten (A) für die Aufhebung des Gleichtaktrauschstroms ($I_c$) und für die Summierung der Differenzströmen ($I_d$) ausgebildet ist, und
Mittel für die Umwandlung des genannten Stroms (I) in Spannung;
in welchem:

- der invertierende Anschluss des ersten Operationsverstärkers (opamp1) und der invertierende Anschluss des zweiten Operationsverstärkers (opamp2) so angeordnet sind, dass sie jeweils mit den Sensoranschlüssen angeschlossen werden können,
- der erste Widerstand (r) zwischen dem invertierenden Anschluss des genannten ersten Operationsverstärkers (opamp1) und seinem Ausgang angeschlossen ist,
- der zweite Widerstand mit demselben Wert (r) zwischen dem invertierenden Anschluss des genannten zweiten Operationsverstärkers (opamp2) und dem Ausgang des genannten ersten Operationsverstärkers (opamp1) angeschlossen ist,
- die nicht invertierende Anschlüsse des genannten ersten und des genannten zweiten Operationsverstärkers (opamp1, opamp2) mit der Referenzspannung angeschlossen sind,
- die Parallelschaltung des Kondensators ($C_f$) und der dritte Widerstand ($R_f$) zwischen dem invertierenden Anschluss des genannten zweiten Operationsverstärkers (opamp2) und seinem Ausgang angeschlossen ist, wobei dieser ebenso der Ausgang des Kreises ist,
- wobei der genannte Knoten (A) durch die gemeinsame Schaltungen des zweiten Widerstands (r), des invertierenden Anschlusses des zweiten Operationsverstärkers (opamp2), des Kondensators ($C_f$) und des dritten Widerstands ($R_f$) bestimmt wird.

3. Verstärker- und Aufbereitungsdifferenzeingangskreis für einen eine Ladung oder Strom erzeugenden Sensor, welcher Sensoranschlüsse aufweist, geeignet für die Erzeugung von einem Gleichtaktrauschstrom ($I_c$) und Differenzströmen ($I_d$), wobei die Ausgangsspannung $V_{out}$ des Differenzeingangskreises jeweils im richtigen Verhältnis in Bezug auf die von dem Sensor bereitgestellte Ladung oder den bereitgestellten Strom steht, wobei der Differenzeingangskreis eine Referenzspannung enthält, und umfassend:

einen ersten und einen zweiten Widerstand (r) mit demselben Wert, einen ersten und einen zweiten Operationsverstärker (opamp1, opamp2), eine Parallelschaltung eines Kondensators ($C_f$) und einen dritten Widerstand ($R_f$);
einen Knoten (A), wobei der Differenzeingangskreis für die Bereitstellung eines Stroms (I) an dem genannten Knoten (A) für die Aufhebung des Gleichtaktrauschstroms ($I_c$) und für die Summierung der Differenzströmen ($I_d$) ausgebildet ist, und
Mittel für die Umwandlung des genannten Stroms (I) in Spannung;
in welchem:

- der invertierende Anschluss des ersten Operationsverstärkers (opamp1) und der invertierende Anschluss des zweiten Operationsverstärkers (opamp2) so angeordnet sind, dass sie jeweils mit den Sensoranschlüssen angeschlossen werden können,
- der erste Widerstand (r) zwischen dem invertierenden Anschluss des genannten ersten Operationsverstärkers (opamp1) und seinem Ausgang angeschlossen ist,
- der zweite Widerstand mit demselben Wert (r) zwischen dem invertierenden Anschluss des genannten zweiten Operationsverstärkers (opamp2) und dem Ausgang des genannten ersten Operationsverstärkers (opamp1) angeschlossen ist,
- die nicht invertierende Anschlüsse des genannten ersten und des genannten zweiten Operationsverstärkers (opamp1, opamp2) mit der Referenzspannung angeschlossen sind,
- die Parallelschaltung des Kondensators ($C_f$) und der dritte Widerstand ($R_f$) zwischen dem invertierenden Anschluss des genannten ersten Operationsverstärkers (opamp1) und dem Ausgang des genannten zweiten Operationsverstärkers (opamp2) angeschlossen ist, wobei dieser ebenso der Ausgang des Kreises ist,
- wobei der genannte Knoten (A) durch die gemeinsame Schaltungen des ersten Widerstands (r), des invertierenden Anschlusses des genannten ersten Operationsverstärkers (opamp1), des Kondensators ($C_f$) und des dritten Widerstands ($R_f$) bestimmt wird.

## Revendications

1. Circuit d'entrée différentielle d'amplification et conditionnement pour un capteur de génération de charge ou courant ayant des terminaux de capteur appropriés pour générer un courant de bruit de mode commun ($I_c$) et des courants différentiels ($I_d$), le voltage de courant $V_{out}$ du circuit d'entrée différentielle étant adaptable a la charge ou courant fourni par le capteur, respectivement, le circuit d'entrée différentielle comportant un voltage de consigne, et comprenant :

un premier et un deuxième résistor (*r*) à valeur identique, un premier et un deuxième amplificateur opérationnel (*opamp1, opamp2*), une liaison parallèle d'un condensateur (*$C_f$*) et un troisième résistor (*$R_f$*) ;
un noeud (A), le circuit d'entrée différentielle étant configuré pour fournir un courant (*I*) audit noeud (A) pour annuler le courant de bruit en mode commun (*$I_c$*) et pour ajouter les courants différentiels (*$I_d$*), et
des moyens pour convertir ledit courant (*I*) en voltage ;
dans lequel :

- les deux points d'entrée du premier amplificateur opérationnel (opamp1) sont disposés pour être respectivement connectables avec les terminaux de capteur,
- le premier résistor (*r*) est connecté entre le terminal inverseur dudit premier amplificateur opérationnel (opamp1) et sa sortie,
- le deuxième résistor à valeur identique (*r*) est connecté entre le terminal non-inverseur dudit premier amplificateur opérationnel (opamp1) et sa sortie.
- le terminal non-inverseur dudit premier amplificateur opérationnel (opamp1) est connecté au terminal inverseur du deuxième amplificateur opérationnel (opamp2),
- le terminal non-inverseur dudit deuxième amplificateur opérationnel (opamp2) est connecté au voltage de consigne, et
- la connexion parallèle du condensateur (*$C_f$*) et le troisième résistor (*$R_f$*) est connectée entre le terminal inverseur dudit deuxième amplificateur opérationnel (opamp2) et sa sortie, qui est également la sortie du circuit,
- ledit noeud (A) étant déterminé par les connexions communes du deuxième résistor, le terminal non-inverseur dudit premier amplificateur opérationnel (opamp1), le terminal inverseur dudit deuxième amplificateur opérationnel (opamp2), le condensateur ($C_f$) et le troisième résistor ($R_f$).

2. Circuit d'entrée différentielle d'amplification et conditionnement pour un capteur de génération de charge ou courant ayant des terminaux de capteur appropriés pour générer un courant de bruit de mode commun ($I_c$) et des courants différentiels ($I_d$), le voltage de courant $V_{out}$ du circuit d'entrée différentielle étant adaptable a la charge ou courant fourni par le capteur, respectivement, le circuit d'entrée différentielle comportant un voltage de consigne, et comprenant :

   un premier et un deuxième résistor ($r$) à valeur identique, un premier et un deuxième amplificateur opérationnel (*opamp1, opamp2*), une liaison parallèle d'un condensateur ($C_f$) et un troisième résistor ($R_f$) ;
   un noeud (A), le circuit d'entrée différentielle étant configuré pour fournir un courant ($I$) audit noeud (A) pour annuler le courant de bruit en mode commun ($I_c$) et pour ajouter les courants différentiels ($I_d$), et
   des moyens pour convertir ledit courant ($I$) en voltage ;
   dans lequel :

      - le terminal inverseur du premier amplificateur opérationnel (opamp1) et le terminal inverseur du deuxième amplificateur opérationnel (opamp2) sont disposés pour être respectivement connectables avec les terminaux de capteur,
      - le premier résistor ($r$) est connecté entre le terminal inverseur dudit premier amplificateur opérationnel (opamp1) et sa sortie,
      - le deuxième résistor à valeur identique ($r$) est connecté entre le terminal inverseur dudit deuxième amplificateur opérationnel (opamp2) et la sortie du premier amplificateur opérationnel (opamp1),
      - les terminaux non-inverseurs desdits premier et deuxième amplificateurs opérationnels (opamp1, opamp2)) sont connectés au voltage de consigne,
      - la connexion parallèle du condensateur ($C_f$) et le troisième résistor ($R_f$) est connectée entre le terminal inverseur dudit deuxième amplificateur opérationnel (opamp2) et sa sortie, qui est également la sortie du circuit,
      - ledit noeud (A) étant déterminé par les connexions communes du deuxième résistor ($r$), le terminal inverseur dudit deuxième amplificateur opérationnel (opamp2), le condensateur ($C_f$) et le troisième résistor

($R_f$).

3. Circuit d'entrée différentielle d'amplification et conditionnement pour un capteur de génération de charge ou courant ayant des terminaux de capteur appropriés pour générer un courant de bruit de mode commun ($I_c$) et des courants différentiels ($I_d$), le voltage de courant $V_{out}$ du circuit d'entrée différentielle étant adaptable a la charge ou courant fourni par le capteur, respectivement, le circuit d'entrée différentielle comportant un voltage de consigne, et comprenant :

   un premier et un deuxième résistor ($r$) à valeur identique, un premier et un deuxième amplificateur opérationnel (*opamp1, opamp2*), une liaison parallèle d'un condensateur ($C_f$) et un troisième résistor ($R_f$) ;
   un noeud (A), le circuit d'entrée différentielle étant configuré pour fournir un courant ($I$) audit noeud (A) pour annuler le courant de bruit en mode commun ($I_c$) et pour ajouter les courants différentiels ($I_d$), et
   des moyens pour convertir ledit courant ($I$) en voltage ;
   dans lequel :

      - le terminal inverseur du premier amplificateur opérationnel (opamp1) et le terminal inverseur du deuxième amplificateur opérationnel (opamp2) sont disposés pour être respectivement connectables avec les terminaux de capteur,
      - le premier résistor ($r$) est connecté entre le terminal inverseur dudit premier amplificateur opérationnel (opamp1) et sa sortie,
      - le deuxième résistor à valeur identique ($r$) est connecté entre le terminal inverseur dudit deuxième amplificateur opérationnel (opamp2) et la sortie du premier amplificateur opérationnel (opamp1),
      - les terminaux non-inverseurs desdits premier et deuxième amplificateurs opérationnels (opamp1, opamp2)) sont connectés au voltage de consigne,
      - la connexion parallèle du condensateur ($C_f$) et le troisième résistor ($R_f$) est connectée entre le terminal inverseur dudit premier amplificateur opérationnel (opamp1) et la sortie dudit deuxième amplificateur opérationnel (opmp2), qui est également la sortie du circuit,
      - ledit noeud (A) étant déterminé par les connexions communes du premier résistor ($r$), le terminal inverseur dudit premier amplificateur opérationnel (opamp1), le condensateur ($C_f$) et le troisième résistor ($R_f$).

FIG. 1

FIG. 2

FIG. 3

FIG. 4

FIG. 5

FIG. 6

FIG. 7

FIG. 8

FIG. 9

FIG. 10

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6104120 A
- EP 1150125 A
- US 5339285 A
- US 5982232 A
- US 4689578 A
- US 5388458 A
- US 20020125943 A

**Non-patent literature cited in the description**

- **BAHRAM ZAND ; KHOMAN PHANG ; DAVID A. JOHNS.** Transimpedance amplifier with differential photodiode current sensing. *IEEE International Symposium on Circuits and Systems,* 1999
- **B.C. BAKER.** Comparison of noise performance between a FET transimpedance amplifier and a switched integrator. *Application Bulletin AB-075A,* 1993
- **A. GANDELLI ; R. OTTOBONI.** Charge amplifiers for piezoelectric sensors. *IEEE International Measurement and Technology Conference,* 1993
- Photodiode monitoring with opamps. **G. GRAEME.** Application Bulletin AB-075. Burr-Brown Corporation, January 1995